(19)

Europäisches
Patentamt
European
Patent Office
Office européen
des brevets

(11) **EP 1 936 421 A1**

(12) **EUROPEAN PATENT APPLICATION**

(43) Date of publication:
**25.06.2008 Bulletin 2008/26**

(51) Int Cl.:
**G02B 17/08** (2006.01)     *G03F 7/00* (2006.01)

(21) Application number: **07018247.2**

(22) Date of filing: **18.09.2007**

(84) Designated Contracting States:
**AT BE BG CH CY CZ DE DK EE ES FI FR GB GR
HU IE IS IT LI LT LU LV MC MT NL PL PT RO SE
SI SK TR**
Designated Extension States:
**AL BA HR MK RS**

(71) Applicant: **Carl Zeiss SMT AG
73447 Oberkochen (DE)**

(72) Inventors:
- **Rostalski, Hans-Jürgen
  73447 Oberkochen (DE)**
- **Bittner, Boris
  91154 Roth (DE)**

(74) Representative: **Patentanwälte
Ruff, Wilhelm, Beier, Dauster & Partner
Kronenstrasse 30
70174 Stuttgart (DE)**

(54) **Catadioptric optical system and catadioptric optical element**

(57)     A catadioptric optical system comprises a plurality of optical elements arranged to image a pattern from an effective object field in an object surface of the optical system to an effective image field in an image surface of the optical system with operating radiation at an operating wavelength. The optical elements include a plurality of lenses and at least one concave mirror. The optical elements include a catadioptric optical element comprising: a body made from a body material transparent to radiation at the operating wavelength, the body having a first surface and a second surface opposite to the first surface, wherein the first surface is a concave surface having a first surface portion and a second surface portion adjacent to the first surface portion, a reflective coating is applied to the first surface portion and the second surface portion is transparent to the operating radiation, whereby the reflective coating forms the concave mirror and the second portion of the first surface forms a concave lens surface. A catadioptric optical element is also disclosed.

Fig. 2

EP 1 936 421 A1

**Description**

BACKGROUND OF THE INVENTION

Field of the Invention

The invention relates to a catadioptric optical system. The optical system may be configured as catadioptric projection objective which may be used in a microlithographic projection exposure apparatus to expose a radiation-sensitive substrate arranged in the region of an image surface of the projection objective with at least one image of pattern of a mask that is arranged in the region of an object surface of the projection objective. The invention also relates to a catadioptric optical element.

Description of the Related Art

Microlithographic projection exposure methods and apparatus are used to fabricate semiconductor components and other finely patterned components. A microlithographic exposure process involves using a mask (reticle) that carries or forms a pattern of a structure to be imaged, for example a line pattern of a layer of a semiconductor component. The pattern is positioned in a projection exposure apparatus between an illumination system and a projection objective in a region of the object surface of the projection objective. Primary radiation from the ultraviolet electromagnetic spectrum (UV radiation) is provided by a primary radiation source and transformed by optical components of the illumination system to produce illumination radiation directed at the pattern of the mask. The radiation modified by the mask and the pattern passes through the projection objective, which forms an image of the pattern in the image surface of the projection objective, where a substrate to be exposed is arranged. The substrate, e.g. a semiconductor wafer, normally carries a radiation-sensitive layer (photoresist).

In order to create even finer structures, it is sought to both increase the image-end numerical aperture (NA) of projection objectives and employ shorter wavelengths, preferably ultraviolet light with wavelengths less than about 260 nm.

There are very few materials, such as synthetic quartz glass (fused silica) and crystalline fluorides, such as calcium fluoride, that are sufficiently transparent in that wavelength region. Since the Abbé numbers of those materials do not differ much, it is difficult to provide purely refractive systems that are sufficiently well color-corrected for chromatic aberrations.

The high prices of the available materials and limited availability of crystalline calcium fluoride in sizes large enough for fabricating large lenses represent problems. Measures that will allow reducing the number and sizes of lenses and simultaneously contribute to maintaining, or even improving, imaging fidelity are thus desired.

In lithography, a flat (planar) image is essential to expose planar substrates, such as semiconductor wafers. However, generally the image surface of an optical system is curved, and the degree of curvature is determined by the Petzval sum. The correction of Petzval sum is becoming more important in view of the increasing demands to project large object fields on planar surfaces with increased resolution.

One approach for obtaining a flat image surface and good color-correction is the use of catadioptric systems, which combine both refracting elements, such as lenses, and reflecting elements, such as mirrors. Typically those optical systems include at least one concave mirror. While the contributions of positive-powered and negative-powered lenses in an optical system to overall power, surface curvature and chromatic aberrations are opposite to each other, a concave mirror has positive power like a positive-powered lens, but the opposite effect on surface curvature without contributing to chromatic aberrations.

SUMMARY OF THE INVENTION

It is one object to provide a catadioptric optical system which may be utilized as projection objective in a microlithography system and which may be manufactured with relatively small amount of optical material.

It is another object to provide a compact catadioptric optical system having moderate size.

It is another object to provide a compact multi-functional catadioptric optical element.

To address these and other objects the invention, according to one formulation of the invention, provides a catadioptric optical system comprising:

a plurality of optical elements arranged to image a pattern from an effective object field in an object surface of the optical system to an effective image field in an image surface of the optical system with operating radiation at an operating wavelength;

the optical elements including a plurality of lenses and at least one concave mirror;

the optical elements including a catadioptric optical element comprising: a body made from a body material transparent to radiation at the operating wavelength, the body having a first surface and a second surface opposite to the first surface;

wherein the first surface is a concave surface having a first surface portion and a second surface portion adjacent to the first surface portion;

a reflective coating is applied to the first surface portion and the second surface portion is transparent to the operating radiation;

whereby the reflective coating forms the concave mirror and the second portion of the first surface forms a concave lens surface.

According to this aspect, the catadioptric optical element may have a double function. In a first function, the reflective coating formed on the first surface portion of concave first surface forms a concave mirror providing positive optical power for radiation incident on and reflected by the reflective coating. The second portion of the first surface forms a concave lens surface which may be utilized to refract radiation passing through the second portion of the first surface either from the side of the body towards the surrounding medium or from the surrounding medium into the transparent body. The body functions both as a mirror substrate for the concave mirror formed by the reflective coating and as a lens body. Therefore, at least two optical functions are integrated in one and the same catadioptric optical element. Material and space can be saved.

In some embodiments the optical elements define a single straight (unfolded) optical axis. Systems of this type are referred to as "in-line systems" in this application. While construction space may be tight in a catadioptric optical in-line system having all optical elements aligned along a straight optical axis, integrating multiple optical functions in one optical element may save construction space, whereby a compact construction may be possible particularly in axial direction. Further, the same mounting structure may be used to mount both a concave mirror and a lens having at least one concave lens surface at a given axial position. Other embodiments may have a folded optical axis. The folding may be effected by one or more planar deflecting mirrors (folding mirrors) inclined relative to the (folded) optical axis.

In some embodiments an anti-reflection coating is applied to the second surface portion of the first surface, whereby reflection losses in the area of the second surface portion may be reduced when compared to an uncoated second surface portion. The reflective coating may be formed next to an anti-reflection coating covering only the second portion of the first surface. For example, both the anti-reflection coating and the reflective coating forming the concave mirror may be coated directly on the first surface of the body.

In some embodiments an anti-reflection coating applied to the first surface extends over the first surface portion and the second surface portion, and the reflective coating is formed on the anti-reflection coating in the first surface portion. In this embodiment the anti-reflection coating may first be formed on the body by any suitable conventional process, such as chemical vapour deposition or physical vapour deposition, and the reflective coating may be coated onto the anti-reflection coating afterwards to cover only a part of the anti-reflection coating corresponding to the first portion of the first surface.

In some embodiments, an anti-reflection coating is applied to the first surface of the body at least in a region opposite to the second portion of the first surface such that reflection losses for radiation transiting through the second portion are reduced.

The reflective coating may be formed by a multilayer stack of layers of dielectric material only to form a dielectric reflective coating. In some embodiments the reflective coating includes a metal layer substantially non-transparent to the operating radiation. The metal layer may be formed from pure aluminium or an aluminium alloy, for example. Other metallic materials are also possible. A dielectric layer system including at least one layer made from dielectric material may be disposed on a radiation entry side of the metal layer. The dielectric layer may be a protective layer with little or no optical effect. In some embodiments, the dielectric layer system is designed to enhance reflection of the reflective coating to form a dielectrically enhanced metal mirror.

The material of the body may be selected according to the range of wavelengths used in field of application of the catadioptric optical system. Materials transparent to ultraviolet radiation may be used for example in applications in the field of microlithography, or microscopy. In some embodiments the material of the body is transparent to radiation at wavelength $\lambda < 260nm$, such as wavelength provided by $KrF_2$ excimer laser (248nm) or an ArF excimer laser (193nm) or an $F_2$ laser (157nm). In some embodiments the material of the body is selected from a group consisting of fused silica (synthetic quartz glass) and an alkaline fluoride crystal material, such as calcium fluoride, barium fluoride or the like.

In some embodiments the catadioptric optical system is a microlithography projection optical system. In these embodiments, both the object surface and the image surface, optically conjugate to the object surface, have a finite distance from the optical elements of the catadioptric optical system. In other embodiments, one of the object surface and the image surface may be at infinity as may be the case for catadioptric optical systems used in a microscope.

There are different ways to incorporate a catadioptric optical element into an optical system including the catadioptric optical element and additional optical elements, such as one or more lenses and/or one or more flat or curved mirrors. In some embodiments the catadioptric optical element is arranged such that the concave first surface is oriented towards the image surface, and a mirror having a reflective surface facing the catadioptric optical element is arranged geometrically between the catadioptric optical element and the image surface such that radiation from the object surface and refracted by the transparent second portion of the first surface is reflected by the reflective surface of the mirror towards the concave mirror formed by the reflective coating of the catadioptric optical element. In these embodiments, radiation coming from the object surface may first pass through the lens portion of the catadioptric optical element and may be refracted by the second surface and the concave second portion of the first surface before the radiation is incident on the mirror on the image-side of the catadioptric optical element. The mirror may have a planar reflective surface or a curved reflective surface (such as a concave reflective surface or a convex reflective surface).

In some embodiments the catadioptric optical element is arranged such that the concave first surface is oriented towards the object surface, and a mirror having a reflective surface facing the catadioptric optical element is arranged geometrically between the catadioptric optical element and the object surface, such that radiation from the object surface is reflected by the concave mirror formed by the reflective coating of the catadioptric optical element towards the reflective surface of the mirror, and radiation reflected by the reflective surface of the mirror is refracted by the second surface portion of the catadioptric optical element between the mirror and the image surface. In those embodiments, radiation may be first incident on the concave mirror formed by the reflective coating of the catadioptric optical element prior to being incident on the mirror, which may be a planar mirror, or a curved mirror, such as a convex mirror or a concave mirror. Radiation reflected from the mirror may then pass through the lens portion of the catadioptric optical element and may be refracted by the second surface portion and the second surface.

In some embodiments no optical element is arranged between the mirror and the catadioptric optical element. However, one or more lenses or one or more mirrors may be arranged between the mirror and the catadioptric optical element.

Some embodiments include a single catadioptric optical element. In other embodiments, a first catadioptric optical element and at least a second catadioptric optical element are provided. The concave surfaces of the catadioptric optical element may be oriented towards the same side of the catadioptric optical system (object-side or image-side). In some embodiments the first catadioptric optical element is oriented such that the concave first surface faces the object surface and the second catadioptric optical element is oriented such that the concave first surface faces the first catadioptric optical element such that the concave mirror formed by the reflective coating of the first catadioptric optical element reflects radiation coming from the object surface towards the concave mirror formed by the reflective coating of the second catadioptric optical element. In those embodiments, the concave mirrors formed by the reflective coatings of the first and second catadioptric optical elements may be arranged on or may extend to opposite sides of the optical axis such that radiation entering a mirror group formed by the concave mirrors formed by the reflective coatings forms a zig-zag-path crossing the optical axis between the first and second catadioptric optical elements prior to exiting the mirror group formed by the reflective coating of the fist and second catadioptric optical elements.

The catadioptric optical system may be designed to image the pattern from the object surface onto the image surface without intermediate image. In some embodiments, the optical elements form a first imaging objective part to image the pattern from the object surface into first intermediate image, and at least one second imaging objective part to image the first intermediate image into a second intermediate image or into the image surface. In these embodiments at least one intermediate image is formed. A higher number of intermediate images, such as two, three, four or five intermediate images or more may be formed if desired.

In some embodiments the optical elements form a first imaging objective part for imaging the pattern into a first intermediate image; a second imaging objective part for imaging the first intermediate image into a second intermediate image; and a third imaging objective part for imaging the second intermediate image into the image surface.

The catadioptric optical system may have exactly two concave mirrors, each formed by a reflective coating on a concave first side of catadioptric optical element. In some embodiments with exactly two concave mirrors only one concave mirror may be formed on such catadioptric optical element. A catadioptric optical system may have more than two curved mirrors, for example another even number of curved mirrors, such as four curved mirrors or six curved mirrors. Embodiments having four curved mirrors are disclosed, for example in US 6,636,350. The disclosure of this patent is incorporated herein by reference.

Various examples of catadioptric in-line optical systems having exactly two concave mirrors and exactly two intermediate images are disclosed, for example, in the applicant's patent application WO 2005/069055 A2 which is incorporated herein by reference.

The invention also relates to a catadioptric optical element comprising: a body made from a body material transparent to radiation at the operating wavelength, the body having a first surface and a second surface opposite to the first surface; wherein the first surface is a concave surface having a first surface portion and a second surface portion adjacent to the first surface portion; a reflective coating is applied to the first surface portion and the second surface portion is transparent to the operating radiation, whereby the reflective coating forms the concave mirror and the second portion of the first surface forms a concave lens surface.

The previous and other properties can be seen not only in the claims but also in the description and the drawings, wherein individual characteristics may be used either alone or in sub-combinations as an embodiment of the invention and in other areas and may individually represent advantageous and patentable embodiments.

BRIEF DESCRIPTION OF THE DRAWINGS

Fig. 1    shows a schematic drawing of an embodiment of a projection exposure apparatus for microlithography having an illumination system and a projection objective;

Fig. 2    shows a meridional lens section of an embodiment of a catadioptric projection objective including two embodiments of catadioptric optical elements to form exactly two concave mirrors; and

Fig. 3    shows a schematic section through an embodiment of a catadioptric optical element.

DETAILED DESCRIPTION OF THE PREFERRED EMBODIMENTS

In the following description of preferred embodiments, the term "optical axis" shall refer to a straight line or sequence of straight-line segments passing through the centers of curvature of the optical elements. In the case of the examples presented here, the object is either a mask (reticle) bearing the pattern of an integrated circuit or some other pattern, for example, a grating pattern. In the examples presented here, the image of the object is projected onto a wafer serving as a substrate that is coated with a layer of photoresist, although other types of substrates, such as components of liquid-crystal displays or substrates for optical gratings, are also feasible.

The terms "front" and "rear" as well as the terms "upstream" and "downstream" relate to relative positions along the optical path, where "front" and "upstream" relate to positions optically closer to the object surface in a projection objective.

Unless stated otherwise the data given for the image-side numerical aperture NA refer to the maximum image-side numerical aperture allowing a reasonable function of the projection objective, i.e. the maximum NA value for which the projection objective is designed (design NA). In systems having a variable size aperture stop the numerical aperture actually used in a process may be set to values smaller than the design NA as desired, for example to increase the depth of field.

Where tables are provided to disclose the specification of a design shown in a figure, the table or tables are designated by the same numbers as the respective figures.

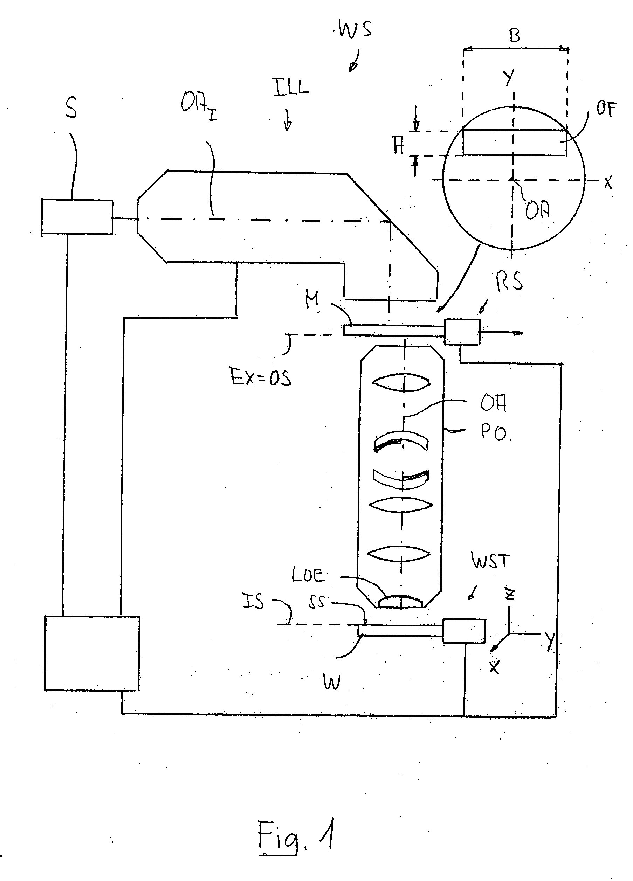

Fig. 1 shows schematically a microlithographic projection exposure apparatus in the form of a wafer scanner WS, which is provided for fabricating large scale integrated semiconductor components in a step-and-scan mode. The projection exposure apparatus comprises as light source an KrF excimer laser S having an operating wavelength of about 248 nm. Other operating wavelengths, such as 193 nm or 157 nm, are also possible in other embodiments. An illumination system ILL generates, in its exit surface EX, a large, sharply delimited, homogeneously illuminated illumination field that is adapted to the telecentric requirements of the downstream catadioptric projection objective PO. The illumination system ILL has devices for selection of the illumination mode and, in the example, can be changed over between conventional on-axis illumination with a variable degree of coherence, and off-axis illumination, particularly annular illumination (having a ring shaped illuminated area in a pupil surface of the illumination system) and dipole or quadrupole illumination.

Arranged downstream of the illumination system is a device RS (reticle stage) for holding and manipulating a mask M in such a way that a pattern formed on the mask lies in the exit surface EX of the illumination system coinciding with the object surface OS of the projection objective PO and can be moved in this plane for a scanning operation in a scanning direction (Y-direction) perpendicular to the optical axis $OA_l$ of the illumination system, which is parallel to, but laterally offset to the optical axis OA of the projection objective. The optical axes run parallel to the the Z-direction.

The reduction projection objective PO is designed to image an image of a pattern provided by the mask with a reduced scale of 4:1 (magnification ratio $|\beta| = 0.25$) onto a wafer W coated with a photoresist layer. The wafer W serving as a light-sensitive substrate is arranged in such a way that the planar substrate surface SS with the photoresist layer essentially coincides with the planar image surface IS of the projection objective. The wafer is held by a device WST (wafer stage) comprising a scanner drive in order to move the wafer synchronously with the mask M in parallel with the latter. The device WS also comprises manipulators in order to move the wafer both in the Z direction parallel to the optical axis OA and in the X and Y directions perpendicular to said axis. A tilting device having at least one tilting axis running perpendicular to the optical axis is integrated.

The projection objective PO has a flat, planoconvex lens as the last optical element LOE nearest to the image surface IS, the planar exit surface of that lens being the last optical surface (exit surface) of the projection objective PO. During operation of the projection exposure apparatus, a gas filled gap is formed between the exit surface of the last optical element and the substrate surface SS.

In other embodiments an immersion system is used where the working distance between the last optical element LOE and the wafer is filled with an immersion liquid (e.g. water). The last optical element LOE may be a plano-convex lens, providing a planar exit surface. In some embodiments, the last optical element may be formed by a plane parallel plate, equally providing a planar exit surface of the projection objective. The exit surface of the projection objective may also be curved. Such curved exit surface may be provided by a last optical element formed like a biconvex lens, for example. In some embodiments the last optical surface (exit surface of the projection objective) may be concave.

As shown schematically in the inset figure of Fig. 1, the illumination system ILL is capable of generating an illumination field having a rectangular shape. The position, size and shape of the illumination field determine the position, size and shape of the effective object field OF (and the effective image field IF) of the projection objective actually used in the projection process. In this example, the illumination system is designed to form an illumination field centered about the optical axis $OA_I$ of the illumination system. The optical axis of the illumination system is laterally offset relative to the optical axis OA of the projection objective to such an extent that the effective object field OF lies at the appropriate position entirely outside the optical axis of the projection objective required to obtain the imaging without vignetting (off-axis field). The effective object field OF has a height A parallel to the scanning direction (Y-direction) and a width B perpendicular to the scanning direction and an aspect ratio AR= B/A of about 104 : 22.

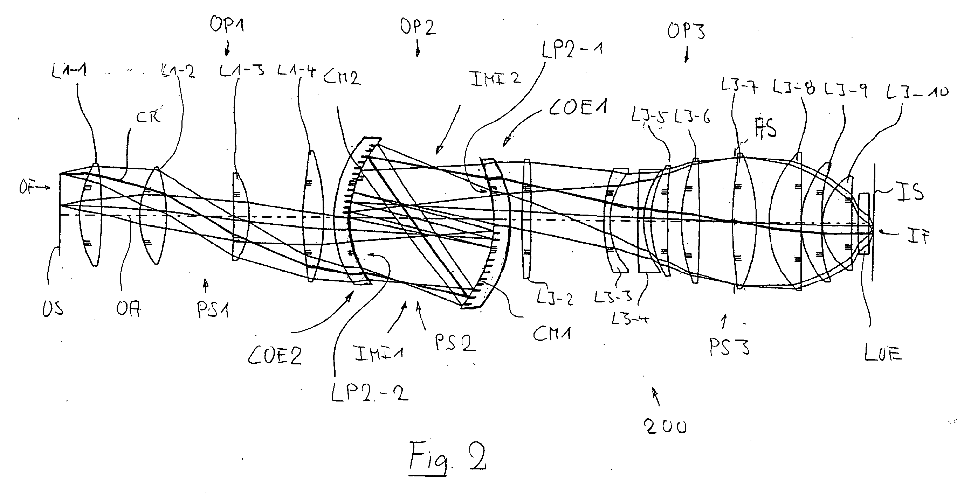

Fig. 2 shows a catadioptric projection objective 200 according to an embodiment of the invention designed for ca. 248 nm UV working wavelength. It is designed to project an image of a pattern on a reticle (mask) arranged in the planar object surface OS (object plane) into the planar image surface IS (image plane) on a reduced scale 4:1, while creating exactly two real intermediate images IMI1, IMI2. A first refractive objective part OP1 is designed for imaging the pattern in the object surface into the first intermediate image IMI1 at an enlarged scale with $1.5 < |\beta_1| < 2.5$. Therefore, the first intermediate image is larger than the effective object field, e.g. by more than 70%. A second, catoptric (purely reflective) objective part OP2 images the first intermediate image IMI1 into the second intermediate image IMI2 at a near unity magnification with $0.6 < |\beta_2| < 1.1$. A third, refractive objective part OP3 images the second intermediate image IMI2 onto the image surface IS with a reduction ratio of about $|\beta_3| = 0.2$. The size of the second intermediate image is therefore significantly larger than the size of the effective image field. An aperture stop AS is placed in the third objective part in the region of the pupil surface PS3 thereof. In other embodiments, the aperture stop may be positioned in the first objective part at or near the pupil surface PS1 thereof.

An off-axis effective object field OF positioned outside the optical axis OA is projected on an off-axis effective image field IF. The trajectory of a chief ray CR of an outer field point of the off-axis object field OF in the meridional plane (drawing plane) is drawn bold in order to facilitate following the beam path. For the purpose of this application, the term "chief ray" (also known as principal ray) denotes a ray emanating from a field point away from the optical axis of the effectively used object field OF and intersecting the optical axis at at least one pupil surface position. Here, three pupil surfaces PS1, PS2 and PS3 are formed, one pupil surface in each objective part. In projection objectives being essentially telecentric on the object side (as in the embodiment), the chief ray emanates from the object surface parallel or at a very small angle with respect to the optical axis. As evident from the figure, the chief ray intersects both the object surface and the image surface essentially at right angles indicating both object-side and image-side telecentricity. The imaging process is further characterized by the trajectory of marginal rays. A "marginal ray" as used herein is a ray running from an axial object field point (on the optical axis) to the edge of an aperture stop AS. That marginal ray may not contribute to image formation because an off-axis effective object field is used to avoid vignetting. The chief ray and marginal ray are chosen to characterize optical properties of the projection objective.

The first, refractive objective part OP1 includes, in this order between the object surface and the first intermediate image, a biconvex positive lens L1-1 with aspheric entry and spherical exit surface, a biconvex lens L1-2 with aspheric entry surface and spherical exit surface, a positive meniscus lens L1-3 having concave, aspheric entry surface and spherical exist surface, a biconvex positive lens L1-4 having aspheric entry surface and spherical exit surface, and a fifth lens formed by a second lens portion LP2-2 of a second catadioptric optical element COE2 discussed in detail below.

The second purely reflective (catoptric) objective part OP2 comprises a first concave mirror CM1 having a concave mirror surface facing the object side, and a second concave mirror CM2 having the concave mirror surface facing the image side. The aspherically curved mirror surfaces are both continuous or unbroken, i.e. they do not have a hole or bore. The mirror surfaces facing each other define a catoptric cavity, which is also denoted intermirror space, enclosed by the curved surfaces defined by the concave mirrors. The intermediate images IMI1, IMI2 (at least the paraxial parts thereof) are both situated inside the cavity well apart from the mirror surfaces.

Each mirror surface of a concave mirror defines a "curvature surface" or "surface of curvature" which is a mathematical surface extending beyond the edges of the physical mirror surface and containing the mirror surface. The first and second concave mirrors are parts of rotationally symmetric curvature surfaces having a common axis of rotational symmetry coinciding with the optical axis OA defined by the first and third objective parts (in-line system).

The third, refractive objective part OP3 has, in this order between the second intermediate image IMI2 and the image surface IS, a first positive meniscus lens with concave, aspheric entry side and spherical exit side formed by a second lens portion LP2-1 of a first catadioptric optical element COE1, a thin positive lens L3-2 with aspheric exit surface, a group of two negative meniscus lenses L3-3, L3-4 concave on their exit sides, a group of two positive lenses, L3-5, L3-6 immediately upstream of the aperture stop AS, a group of four immediately consecutive positive lenses L3-7 to L3-10 converting the beam from the aperture stop towards the image surface, and a relatively flat plano-convex last optical element LOE having a planar exit surface arranged at a finite image side-working distance of about 6 mm from the image surface IS.

The objective 200 is rotationally symmetric and has one straight optical axis OA common to all refractive and reflective optical components.

There are no folding mirrors. The concave mirrors have small size and are arranged close together and rather close to the intermediate images lying in between. The concave mirrors are both off-axis sections of axial symmetric surfaces. The radiation beam passes by the edges of the concave mirrors facing the optical axis without vignetting. The exit pupil is circular without obscuration and is centered about the optical axis.

The total number of lenses refracting the beam is 16, providing 32 refracting optical surfaces in total. In addition, the optical system includes two concave mirrors CM1, CM2, each providing positive optical power to converge incident radiation. Therefore, the total number of optical surfaces is 34 (32 refractive surfaces and 2 reflective surfaces). The 34 optical surfaces are provided by 16 optical components to be mounted successively in axial direction. Since both catadioptric optical elements COE1, COE2 each provide a concave mirror and a refracting lens portion, installation space can be used more effectively particularly in or close to the second objective part OP2 including the concave mirrors CM1, CM2.

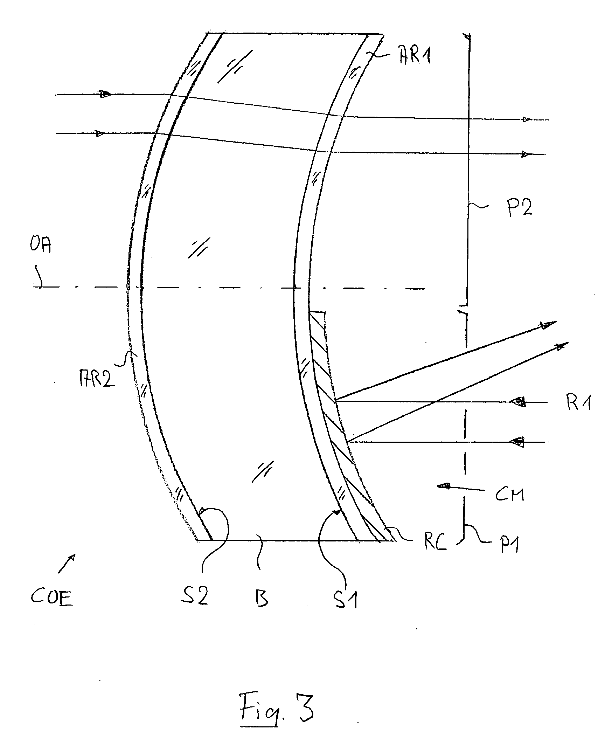

Details of a catadioptric optical element COE, which may be used in the embodiment of Fig. 2 or in other catadioptric optical systems, will now be discussed with regard to the schematic lens section shown in Fig. 3. The catadioptric optical element COE has a body B made from a transparent material with optical quality and absorption properties adapted to the wavelength range for which the optical element is used. Where the body is made from fused silica, applications are possible down to ultraviolet wavelengths of about $\lambda=180$ nm essentially without absorption loss. The body may also be made from an alkaline fluoride crystal material, such as calcium fluoride, extending the range of applicability to smaller wavelengths such as 157nm or below.

The body has a concave first surface S1, which may be a spherical or an aspherical surface. A second surface S2 on the opposite side of body B may be convex, as in the embodiment. The second surface S2 may also be a planar surface or a concave surface, spherical or aspherical, as desired. The centers of curvatures of the first and second surface S1, S2 define the optical axis OA of the catadioptric optical element. The first surface S1 is coated with a dielectric anti-reflection coating AR1 across the entire area optically used in operation. Likewise, second surface S2 is coated with a second anti-reflection coating AR2. A reflective coating RC is coated on the anti-reflection coating AR1 of a first surface S1 in a first portion P1 thereof. In the embodiment, the reflective coating includes a metal layer made of aluminum deposited directly to the anti-reflection coating AR1, and a stack of alternating dielectric layers having different refractive index to protect the metal layer from corrosion and to enhance reflectivity of the reflective coating when compared to an uncoated metal layer.

The first portion P1 covered with the reflective coating forms a concave mirror CM capable of reflecting radiation R1 incident from the concave side of the catadioptric optical element with positive optical power determined by the radius of curvature of the reflective coating. In the embodiment, the reflective coating RC does not extend into the region of the optical axis OA or beyond. The reflective coating RC may cover more than 10% of the entire optically used area of the first surface S1, for example 20% or more, or 30% or more, or 40% or more. In many embodiments, the first portion may be less than 50% or less than 60% or less than 70% of the entire optically used area of the first surface.

The second portion P2 of the first surface only coated with the anti-reflection coating AR1 is transparent to the radiation and effective as a concave refractive optical surface. The second portion P2 forms a lens portion of the catadioptric optical element. The optical power of the lens portion is determined by the relative curvatures of the first and second surfaces and may have the action of a positive lens (as in the embodiment) or as a negative lens, where desired.

As the transparent portion P2 and the concave mirror CM are formed on the same optical surface (first surface S1) prepared with conventional optical preparation methods prior to coating with a reflective coating, the radius of curvature and, where applicable, the aspheric deformation, are the same for the concave, transparent lens portion P2 and the concave mirror CM. Both the concave refracting surface and the concave mirror will be positioned on the same axial position when the catadioptric optical element is mounted within an optical system. A single mounting structure is sufficient to mount both the lens portion P2 and the concave mirror CM formed by the reflective coating, whereby mounting is facilitated.

In the embodiment of Fig. 2, two catadioptric optical elements are mounted at immediately consecutive position in the axial direction such that the concave sides are facing each other. The second catadioptric optical element COE2 is arranged such that the concave first surface is oriented towards the image surface. The first catadioptric optical element COE1 is arranged such that the concave first surface is oriented towards the object surface.

Radiation coming from the object surface OS is first passed through the transparent lens portion LP2-2 of the second catadioptric optical element prior to forming the first intermediate image IMI1. Due to the relative surface curvatures of the first and second surface of the transparent body, this lens portion provides a small amount of positive refractive power. The aspheric shape of the concave first surface may contribute to defining the correction status of first intermediate image IMI1. Radiation is subsequently incident on the reflective coating of the first catadioptric optical element COE1 forming the first concave mirror CM1. First concave mirror CM1 reflects radiation backwards and inwardly to cross the optical axis OA prior to incidence on second concave mirror CM2 formed by the reflective coating of the second catadioptric optical element COE2. The positive optical power of second concave mirror CM2 converges the beam towards the second intermediate image IMI2 formed immediately downstream of the second concave mirror CM2 and upstream of the transparent second portion LP2-1 of first catadioptric optical element COE1. The transparent second portion of first catadioptric optical element COE1 acts in a manner of the field lens on the radiation and may contribute to optical correction.

One or more baffles or blinds may be provided, for example between the reflective portion and the transmissive portion of a surface area of one or both catadioptric optical elements, to prevent stray light from interfering with the image formation in the image surface IS of the projection objective.

The projection objective 200 is designed as a "dry objective" for $\lambda$ = 248 nm having a maximum image side numerical aperture NA = 0.93 in an off-axis effective image field with height A=5.5 mm and width B=26 mm. The total track length (axial distance between object surface and image surface) is 1250 mm. The optical correction for aberrations is characterized by a root-mean-square (RMS) of the wavefront error equal to or smaller than 4 m$\lambda$ for all image heights. There are only 16 lenses. The overall number of lenses is equal to the overall number of optical elements. All lenses are made of fused silica. Typical resolutions of R $\leq$ 80 nm can be obtained.

The specification for this design is summarized in Tables 2, 2A given below.

The above description of the preferred embodiments has been given by way of example. From the disclosure given, those skilled in the art will not only understand the present invention and its attendant advantages, but will also find apparent various changes and modifications to the structures and methods disclosed. It is sought, therefore, to cover all changes and modifications as fall within the spirit and scope of the invention, as defined by the appended claims, and equivalents thereof.

The content of all the claims is made part of this description by reference.

The following tables 2 summarize specifications of the embodiment described above. Column 1 specifies the number of a refractive surface or a reflective surface or a surface distinguished in some other way, column 2 specifies the radius r (radius of curvature) of the surface (in mm), column 3 specifies the distance d - also denoted as thickness - between the surface and the subsequent surface (in mm), and column 4 specifies the material of the optical components. Column 5 indicates the refractive index of the material, and column 6 specifies the optically free radius or the optically free semidiameter (or the lens height) of a lens surface or other surfaces (in mm). Radius r=0 corresponds to a planar surface.

Table 2A specifies the corresponding aspheric data. The aspheric surfaces are calculated according to the following specification:

$$p(h)=[((1/r)h^2)/(1+SQRT(1-(1+K)(1/r)^2h^2))]+C1*h^4+C2*h^6+..$$

In this case, the reciprocal (1/r) of the radius specifies the surface curvature and h specifies the distance between a surface point and the optical axis (i.e. the ray height). Consequently, p(h) specifies the so-called sagitta, that is to say the distance between the surface point and the surface vertex in the z direction (direction of the optical axis). Constant K is the conic constant, and parameters, C1, C2 are aspheric constants.

**Table 2**

NA = 0.93; $\lambda$ = 248 nm; A=5.5 mm; B=26

| SURF | RADIUS | THICKNESS | MATERIAL | INDEX | SEMIDIAM. |
|---|---|---|---|---|---|
| 0 | 0.000 | 29.999 | | | 63.79 |
| 1 | 139.997 | 32.770 | SIO2 | 1.50883663 | 75.255 |
| 2 | -490.005 | 54.886 | | | 75.403 |
| 3 | 135.003 | 39.055 | SIO2 | 1.50883663 | 70.99 |

(continued)

NA = 0.93; λ = 248 nm; A=5.5 mm; B=26

| SURF | RADIUS | THICKNESS | MATERIAL | INDEX | SEMIDIAM. |
|---|---|---|---|---|---|
| 4 | -241.812 | 102.080 | | | 68.953 |
| 5 | -498.241 | 24.195 | SIO2 | 1.50883663 | 59.489 |
| 6 | -122.800 | 86.281 | | | 63.126 |
| 7 | 358.109 | 35.287 | SIO2 | 1.50883663 | 98.721 |
| 8 | -313.981 | 16.000 | | | 100.1 |
| 9 | 194.501 | 25.000 | SIO2 | 1.50883663 | 104.015 |
| 10 | 170.036 | 224.439 | | | 99.69 |
| 11 | -201.591 | -224.439 | REFL | | 135.978 |
| 12 | 170.036 | 224.439 | REFL | | 115.703 |
| 13 | -201.591 | 25.000 | SIO2 | 1.50883663 | 83.981 |
| 14 | -175.510 | 24.409 | | | 87.497 |
| 15 | 1638.465 | 10.662 | SIO2 | 1.50883663 | 86.985 |
| 16 | 1254.881 | 104.186 | | | 86.763 |
| 17 | 285.321 | 9.628 | SIO2 | 1.50883663 | 78.071 |
| 18 | 118.287 | 47.119 | | | 73.985 |
| 19 | 962.468 | 9.628 | SIO2 | 1.50883663 | 76.254 |
| 20 | 136.876 | 9.936 | | | 77.324 |
| 21 | 175.854 | 25.069 | SIO2 | 1.50883663 | 80.359 |
| 22 | -3969.887 | 21.116 | | | 81.428 |
| 23 | 211.877 | 28.766 | SIO2 | 1.50883663 | 93.036 |
| 24 | -2800.443 | 55.477 | | | 93.72 |
| 25 | 0.000 | -3.529 | | | 99.29 |
| 26 | 446.955 | 37.172 | SIO2 | 1.50883663 | 100.358 |
| 27 | -259.168 | 18.924 | | | 101.857 |
| 28 | 154.709 | 48.989 | SIO2 | 1.50883663 | 105.001 |
| 29 | 1816.718 | 0.963 | | | 102.62 |
| 30 | 139.970 | 31.421 | SIO2 | 1.50883663 | 90.03 |
| 31 | 1812.308 | 0.963 | | | 85.295 |
| 32 | 92.569 | 42.600 | SIO2 | 1.50883663 | 70.822 |
| 33 | -1257.042 | 9.660 | | | 63.348 |
| 34 | 603.539 | 15.851 | SIO2 | 1.50883663 | 42.514 |
| 35 | 0.000 | 5.997 | | | 31.258 |
| 36 | 0.000 | 0.000 | | | 15.948 |

## Table 2A

## Aspheric Constants

| SRF | 1 | 3 | 5 | 7 | 11 |
|---|---|---|---|---|---|
| K | 0 | 0 | 0 | 0 | -2.76181 |
| C1 | -7.6448660E-08 | -2.3191860E-08 | 1.5743710E-07 | -4.8590670E-08 | -3.3124830E-08 |
| C2 | -1.0504590E-11 | 1.3830030E-11 | -2.6471870E-11 | 1.2276330E-12 | 5.6970590E-13 |
| C3 | 6.0985780E-16 | -1.9815110E-15 | 5.1809810E-15 | -7.6169910E-17 | -1.4754910E-17 |
| C4 | -7.9029760E-20 | -1.0014280E-19 | -8.4128690E-19 | 3.3434160E-21 | 3.9013380E-22 |
| C5 | 7.4842140E-24 | 1.8661500E-23 | 9.3175400E-23 | -1.4042550E-25 | -7.9443880E-27 |
| C6 | -3.5566110E-28 | -4.7734000E-28 | -5.2040710E-27 | 2.3530310E-30 | 9.5383160E-32 |

| SRF | 12 | 16 | 17 | 22 | 23 |
|---|---|---|---|---|---|
| K | -0.551493 | 0 | 0 | 0 | 0 |
| C1 | 5.535677E-09 | -2.894632E-08 | 1.515022E-07 | 8.418358E-08 | -4.426513E-08 |
| C2 | 1.060155E-13 | 1.666561E-13 | -7.939637E-12 | 1.265600E-12 | -1.519387E-12 |
| C3 | 2.570548E-18 | -2.696635E-16 | 7.637626E-16 | 5.235908E-16 | 3.143145E-16 |
| C4 | 3.611924E-23 | 1.865125E-21 | -1.115116E-19 | -3.619342E-20 | -3.247474E-20 |
| C5 | 1.986460E-28 | -1.647219E-26 | 8.377802E-24 | 4.481707E-24 | 2.915030E-24 |
| C6 | 5.187960E-32 | 2.890611E-29 | -5.250864E-28 | -2.001552E-28 | -1.187674E-28 |

| SRF | 26 | 29 | 31 | 33 |
|---|---|---|---|---|
| K | 0 | 0 | 0 | 0 |
| C1 | -4.250419E-08 | -4.494672E-08 | 2.003502E-07 | 6.578037E-08 |
| C2 | 8.355201E-13 | 7.254247E-13 | -4.503767E-12 | 7.114826E-12 |
| C3 | -1.503279E-17 | 4.574318E-16 | 8.891604E-17 | 2.720378E-16 |
| C4 | -3.901587E-21 | -2.842644E-20 | -2.011440E-20 | -9.164130E-20 |
| C5 | 5.226875E-26 | -1.689023E-25 | -2.445824E-24 | 1.593209E-23 |
| C6 | -1.274529E-29 | 4.331370E-29 | 7.190522E-29 | -4.333632E-28 |

**Claims**

1. A catadioptric optical system comprising:

   a plurality of optical elements arranged to image a pattern from an effective object field in an object surface of the optical system to an effective image field in an image surface of the optical system with operating radiation at an operating wavelength;
   the optical elements including a plurality of lenses and at least one concave mirror;
   the optical elements including a catadioptric optical element comprising: a body made from a body material transparent to radiation at the operating wavelength, the body having a first surface and a second surface opposite to the first surface;

   wherein the first surface is a concave surface having a first surface portion and a second surface portion adjacent to the first surface portion;
   a reflective coating is applied to the first surface portion and the second surface portion is transparent to the operating radiation;
   whereby the reflective coating forms a concave mirror and the second portion of the first surface forms the concave lens surface.

2. The optical system according to claim 1, wherein the optical elements define a single straight optical axis.

3. The optical system according to claim 1 or 2, further comprising an anti-reflection coating applied to the second surface portion of the first surface.

4. The optical system according to one of the preceding claims, further comprising an anti-reflection coating applied to the first surface extending over the first surface portion and the second surface portion, wherein the reflective coating is formed on the anti-reflection coating in the first surface portion.

5. The optical system according to one of the preceding claims, further comprising an anti-reflection coating applied to the first surface of the body.

6. The optical system according to one of the preceding claims, wherein the material of the body is transparent to radiation at wavelength $\lambda < 260$ nm, wherein preferably the material of the body is selected from the group consisting of fused silica and an alkaline fluoride crystal material.

7. The optical system according to one of the preceding claims, wherein the reflective coating includes a metal layer substantially non-transparent to the operating radiation, wherein preferably a dielectric layer system including at least one layer made from a dielectric material is disposed on a radiation entry side of the metal layer and/or wherein preferably the metal layer contains aluminum.

8. The optical system according to one of the preceding claims, wherein the catadioptric optical system is a microlithography projection optical system.

9. The optical system according to one of the preceding claims,
wherein the catadioptric optical element is arranged such that the concave first surface is oriented towards the image surface;
a mirror having a reflective surface facing the catadioptric optical element is arranged geometrically between the catadioptric optical element and the image surface;
such that radiation from the object surface and refracted by the transparent second portion of the first surface is reflected by the reflective surface of the mirror towards the concave mirror formed by the reflective coating of the catadioptric optical element.

10. The optical system according to one of the preceding claims,
wherein the catadioptric optical element is arranged such that the concave first surface is oriented towards the object surface;
a mirror having a reflective surface facing the catadioptric optical element is arranged geometrically between the catadioptric optical element and the object surface,
such that radiation from the object surface is reflected by the concave mirror formed by the reflective coating of the catadioptric optical element towards the reflective surface of the mirror, and radiation reflected by the reflective surface of the mirror is refracted by the second surface portion of the catadioptric optical element between the mirror and the image surface.

11. The optical system according to claim 9 or 10, wherein no optical element is arranged between the mirror and the catadioptric optical element.

12. The optical system according to one of the preceding claims, wherein the optical system includes a first catadioptric optical element and a second catadioptric optical element.

13. The optical system according to claim 12, wherein the first catadioptric optical element is oriented such that the concave first surface faces the object surface and the second catadioptric optical element is oriented such that the concave first surface faces the first catadioptric optical element such that the concave mirror formed by the reflective coating of the first catadioptric optical element reflects radiation coming from the object surface towards the concave mirror formed by the reflective coating of the second catadioptric optical element.

14. The optical system according to one of the preceding claims, wherein the optical elements form:

a first imaging objective part to image the pattern from the object surface into first intermediate image and at least one second imaging objective part to image the first intermediate image into a second intermediate image or into the image surface.

**15.** The optical system according to one of the preceding claims, wherein the optical elements form:

a first imaging objective part for imaging the pattern into a first intermediate image;
a second imaging objective part for imaging the first intermediate image into a second intermediate image; and
a third imaging objective part for imaging the second intermediate image into the image surface.

**16.** The optical system according to claim 15, wherein a first concave mirror having a first continuous mirror surface and at least one second concave mirror having a second continuous mirror surface are arranged upstream of the second intermediate image, at least one of the first concave mirror and the second concave mirror being formed by a reflective coating of the catadioptric optical element;

wherein pupil surfaces are formed between the object surface and the first intermediate image, between the first intermediate image and the second intermediate image, and between the second intermediate image and the image surface; and

all concave mirrors are arranged optically remote from a pupil surface.

**17.** A catadioptric optical element comprising:

a body made from a body material transparent to radiation at an operating wavelength, the body having a first surface and a second surface opposite to the first surface;

wherein the first surface is a concave surface having a first surface portion and a second surface portion adjacent to the first surface portion;
a reflective coating is applied to the first surface portion and the second surface portion is transparent to the operating radiation;
whereby the reflective coating forms a concave mirror and the second portion of the first surface forms a concave lens surface.

**18.** The optical system according to claim 17, **characterized by** the features of the characterizing part of at least one of claims 3 to 7.

Fig. 1

Fig. 2

Fig. 3

**European Patent Office**

**EUROPEAN SEARCH REPORT**

Application Number

EP 07 01 8247

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MAKSUTOV D D: "NEW CATADIOPTRIC MENISCUS SYSTEMS" JOURNAL OF THE OPTICAL SOCIETY OF AMERICA, AMERICAN INSTITUTE OF PHYSICS. NEW YORK, US, vol. 34, no. 5, May 1944 (1944-05), pages 270-284, XP001014193 | 1-11,17,18 | INV. G02B17/08 ADD. G03F7/00 |
| Y | 1.Preface, 3. Principle of meniscus systems, 7. Newton and herschelian systems, Gregorian and cassegrainian systems* figures 8,11,18 * ----- | 14-16 | |
| X | EP 0 266 005 A (PHILIPS NORDEN AB [SE]; PHILIPS NV [NL]) 4 May 1988 (1988-05-04) * column 4, lines 14-33; figures 2-4 * ----- | 1-10,12,13,17,18 | |
| Y | EP 0 433 613 A (HORIBA LTD [JP]) 26 June 1991 (1991-06-26) * column 9, lines 21-43; claim 32; figure 4 * ----- | 14 | |
| Y | WO 2005/069055 A (ZEISS CARL SMT AG [DE]; SHAFER DAVID [US]; ULRICH WILHELM [DE]; DODOC) 28 July 2005 (2005-07-28) * page 31, line 19 - page 34, line 10; figures 1-3,25,40 * * page 52, line 24 - page 55, line 7 * * page 71, line 7 - page 72, line 26 * ----- | 15,16 | TECHNICAL FIELDS SEARCHED (IPC) G02B G03F |
| A | WO 99/47949 A (QUESTAR CORP [US]; UNIV DUKE [US]; KNIGHT DOUGLAS M SR [US]; MACHEMER) 23 September 1999 (1999-09-23) * page 3, line 18 - page 4, line 15; figure 1 * ----- | 1-18 | |

The present search report has been drawn up for all claims

| Place of search | Date of completion of the search | Examiner |
|---|---|---|
| Munich | 8 February 2008 | Casse, Martin |

EPO FORM 1503 03.82 (P04C01)

# EP 1 936 421 A1

## ANNEX TO THE EUROPEAN SEARCH REPORT
## ON EUROPEAN PATENT APPLICATION NO.

EP 07 01 8247

This annex lists the patent family members relating to the patent documents cited in the above-mentioned European search report.
The members are as contained in the European Patent Office EDP file on
The European Patent Office is in no way liable for these particulars which are merely given for the purpose of information.

08-02-2008

| Patent document cited in search report | | Publication date | Patent family member(s) | | Publication date |
|---|---|---|---|---|---|
| EP 0266005 | A | 04-05-1988 | JP | 63141013 A | 13-06-1988 |
| | | | SE | 455237 B | 27-06-1988 |
| | | | SE | 8604590 A | 29-04-1988 |
| | | | US | 4867547 A | 19-09-1989 |
| EP 0433613 | A | 26-06-1991 | DE | 69010868 D1 | 25-08-1994 |
| | | | DE | 69010868 T2 | 23-02-1995 |
| | | | JP | 2048820 C | 25-04-1996 |
| | | | JP | 3148044 A | 24-06-1991 |
| | | | JP | 7076745 B | 16-08-1995 |
| | | | US | 5136422 A | 04-08-1992 |
| WO 2005069055 | A | 28-07-2005 | EP | 1709472 A2 | 11-10-2006 |
| | | | JP | 2007518125 T | 05-07-2007 |
| | | | KR | 20060129379 A | 15-12-2006 |
| WO 9947949 | A | 23-09-1999 | AU | 2767899 A | 11-10-1999 |
| | | | EP | 1062530 A1 | 27-12-2000 |
| | | | IL | 138386 A | 10-04-2003 |
| | | | JP | 2002507758 T | 12-03-2002 |

EPO FORM P0459

For more details about this annex : see Official Journal of the European Patent Office, No. 12/82

17

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6636350 B

- WO 2005069055 A2